# EUROPEAN PATENT SPECIFICATION

(11) **EP 4 432 419 B1**
(45) Date of publication and mention of the grant of the patent: **07.05.2025**
(21) Application number: 23161614.5
(22) Date of filing: 13.03.2023
(51) Int. Cl.: H01M 10/42, G01R 31/385

(54) **TEST STAND WITH TEMPERATURE SENSORS FOR EVALUATING A MATERIAL INTENDED FOR USE IN A BATTERY AND TEST METHOD USING THE TEST STAND**
PRÜFSTAND MIT TEMPERATURSENSOREN ZUR BEURTEILUNG EINES MATERIALS ZUR VERWENDUNG IN EINER BATTERIE UND TESTVERFAHREN MIT DEM PRÜFSTAND
BANC D'ESSAI AVEC CAPTEURS DE TEMPÉRATURE POUR ÉVALUER UN MATÉRIAU DESTINÉ À ÊTRE UTILISÉ DANS UNE BATTERIE ET PROCÉDÉ D'ESSAI UTILISANT LE BANC D'ESSAI

(43) Date of publication of application: 18.09.2024
(73) Proprietor: Henkel AG & Co. KGaA, 40589 Düsseldorf (DE)
(72) Inventor: Kreiskoether, Kim Dana, 40589 Düsseldorf (DE); Franken, Uwe, 41542 Dormagen (DE); Lee, Keon Woo, 40489 Düsseldorf (DE); Lammerschop, Olaf, 47802 Krefeld (DE)
(74) Representative: Patentanwälte Bauer Vorberg Kayser

(56) References cited:
- EP-A1- 3 460 870
- CN-A- 112 526 360
- US-A1- 2018 095 139

## Description

The invention relates to a test stand for evaluating a material that can be used in a battery under conditions that can occur during a thermal runaway.

Nowadays, high-voltage batteries are used in numerous applications, especially in connection with electromobility. For this purpose, individual battery cells are assembled into larger battery arrays. The individual battery cells, which are often designed as cylindrical battery cells, are arranged close together next to each other in a battery housing and connected in series and/or in parallel. Depending on the number and type of battery cells used, a battery can thus store an amount of energy that enables electric driving for several 100 km without intermediate charging.

A local short-circuit between the internal electrodes of a battery cell leads to a high short-circuit current that heats up the battery cell extremely quickly. Mechanical damage from the outside or thermal overheating, for example due to the failure of a battery cooling system, can also lead to extreme heating or thermal runaway of the battery cell. This thermal runaway of a battery cell can easily or quickly spread to neighbouring battery cells. This leads to a chain reaction, whereby the energy stored in the battery is released explosively. This explosive release of energy, which is also referred to as thermal propagation, can be accompanied by toxic gases and the formation of flames and sparks.

It is known from the prior art to provide a material with low thermal conductivity, high dielectric strength and high thermal (fire) resistance between the individual battery cells in order to reduce the risk of thermal propagation. For example, it is known from EP 3 753 056 B1 to embed the individual battery cells in a potting compound consisting of a polyurethane foam with a high proportion of flame retardant. The polyurethane foam should preferably have a flame resistance of level V0, measured according to the UL 94 test for the flammability of plastics.

The UL 94 test is performed with an open flame. The classification determined during the test (e.g. level V0) is of limited value with regard to the suitability of a material for use in a battery with the aim of avoiding thermal propagation as far as possible, as the test conditions differ significantly from the conditions in a battery. Therefore, materials such as the potting compound made of polyurethane are also tested in batteries in which thermal propagation of a battery cell is initiated. However, this is done in non-standard set-ups or methods, as each battery manufacturer uses its own battery design for the test stand. The test results of an initiated thermal runaway obtained in this way are therefore not directly comparable with each other.

CN 112526360 A discloses a test stand according to the preamble of claim 1.

The invention is based on the object of providing a further test stand for a material that can be used in a battery, which ensures a good balance between effort (costs, working time, test environment) and benefit with regard to material evaluation and the evaluation of processes in the battery during a thermal runaway.

The object underlying the invention is achieved with the combination of features according to claim 1. Examples of embodiments of the invention can be taken from the subclaims to claim 1.

According to the invention, the test stand for evaluating a material that can be used in the battery under conditions that can occur during a thermal runaway has a first temperature sensor and and at least a second temperature sensor, the first temperature sensor and the second temperature sensor being arranged in the inner space, and a distance A₁ between the initiation cell and the first temperature sensor and a distance A₂ between the initiation cell and the second temperature sensor being different from one another. The respective temperature sensor thereby preferably detects the time course of the temperature from the time of activation of the initiation cell. The comparison of the time courses of the differently positioned temperature sensors allows important conclusions to be drawn about how thermal propagation spreads in the inner space.

According to the invention, the housing has a housing base which lies in an X-Y plane and from which the initiation cell and the battery cells extend vertically in a Z direction, whereby a third temperature sensor is provided which measures the temperature at a height in the Z direction which is different from the height at which the temperature is measured by the first temperature sensor and/or the temperature is measured by the second temperature sensor. Through the third temperature sensor and its measurement results, statements can be made about the thermal propagation along the Z-axis. For example, this makes it possible to describe the influence of thermal bridges between neighboring cells (for example, due to the wiring between the cells) if these are present at a certain height in the inner space of the housing.

According to the invention, at least one of the temperature sensors project vertically upwards from below through an opening in the base of the housing. The height of the temperature sensor in the inner space can be fixed by a screw connection. By the height of the temperature sensor is meant the height at which the temperature is detected. If the temperature sensor is a thermocouple with a measuring tip, for example, the height of the measuring tip corresponds to the height of the temperature sensor. The screw connection makes it possible to define the height of the temperature sensor particularly flexibly and precisely. In one embodiment, at least 80% or even all of the temperature sensors used in the test stand protrude through the bottom of the housing.

According to the invention, the test stand has several feet on which the housing is supported so that a free space remains between the housing floor and a ground on which the test stand stands. This free space is for the mounting and arrangement of the temperature sensors, which protrude from below through the building floor.

In one embodiment, a n-th order battery cell is arranged between the initiation cell and a (n+1)-th order battery cell (n = 1, 2, 3, ...), and wherein, as viewed from the initiation cell, the first temperature sensor is provided in front of the n-th order battery cell and the second temperature sensor is provided behind the n-th order battery cell. The smaller the order, the smaller the distance between the initiation cell and the battery cell.

When the initiation cell is activated, the first temperature sensor, located closer to the initiation cell, will initially be exposed to higher temperatures, with the n-th-order battery cell providing a kind of heat shield for the second temperature sensor and also for the (n+1)-th order battery cell. In particular, when thermal propagation also causes the nth-order battery cell to release energy, there is a significant temperature rise at the second temperature sensor. This arrangement of temperature sensors therefore makes it possible to record the time until the n-th order battery cell also releases itsself energy.

The initiation cell and the battery cells may be arranged in a honeycomb pattern in which the cells being not located at the border of the honeycomb pattern each have six neighboring cells located on the corners of an equilateral hexagon having a side length equal to a distance between the cell and the neighboring cell.

Due to the honeycomb pattern, the initiation cell has six neighboring cells, each of which is arranged at the same distance A from the initiation cell. When the initiation cell is activated, all six neighboring cells are therefore affected in the same way by the energy released by the initiation cell. In a preferred embodiment, the initiation cell is arranged in the center of the honeycomb pattern, wherein 6n nth-order battery cells with n = 1, 2, 3,.., N are provided around the initiation cell, and wherein a distance between the initiation cell and an n-th order battery cell corresponds to n times A. In an embodiment example, N is equal to 5, so that six first-order battery cells, 12 second-order battery cells, 18 third-order batteries, 24 fourth-order battery cells, and 30 fifth-order battery cells are provided. The second-order battery cells are arranged on an equilateral hexagon whose side length is equal to 2A. The 12 battery cells are arranged at the six corners of the hexagon and centrally between each of the six corners. The fifth-order battery cells are located on an outermost hexagon with a side length of 5A. Together with the centrally arranged indexing cell, the honeycomb pattern of this embodiment thus has a total of 91 cells. The battery cells preferably have a basic cylindrical shape with a longitudinal axis and a circular cross-section. A length L of the battery cell may be a factor of 3, 5 or even 7 greater than the greatest spatial extent perpendicular to the longitudinal axis. In the case of a battery cell with a circular cross section, the largest spatial extent corresponds to a diameter D.

Preferably, the cells arranged in the honeycomb pattern are accommodated in a honeycomb-shaped housing. This allows a particularly compact enclosure of the honeycomb pattern.

As an alternative to the honeycomb pattern, in another embodiment the initiation cell and the battery cells are arranged next to each other in a row. In this case, the initiation cell can be arranged in the middle or in a central position, so that when the initiation cell is activated, the thermal propagation spreads in two directions along the row. However, the initiation cell can also be an outer cell, so that the thermal propagation only propagates in one direction. The cells preferably have a prismatic or cuboidal base shape here, where a flat base side of a battery cell may face a flat base side of an adjacent cell. The housing is preferably cuboidal here.

In a preferred embodiment, the spatial extents of the battery cell correspond to the spatial extents of the initiation cell. For example, if the battery cell is a cylinder, the initiation cell may also be a cylinder with the same length and diameter D. This ensures a realistic test environment, since thermal propagation in a real battery originates from a (defective) battery cell, which is simulated in the test by the activatable initiation cell.

The material to be evaluated, which is tested in the test stand, may be an insulating material that may be provided between the individual battery cells. The insulating material may be a curable potting compound poured into the gaps between the battery cells. However, the material to be evaluated may also be the material surrounding channels of a battery cooling system that can be used to cool the individual battier cells. The material for embedding the channels of the battery cooling usually has a higher thermal conductivity than the thermal insulation material between the battery cells.

The temperature sensors can be arranged on a straight line. In one embodiment, the line intersects the initiation cell. In another embodiment, the temperature sensors used are arranged on two or three straight lines (one group of temperature sensors on each line). The lines may be parallel or may intersect.

The housing may include a plurality of sidewalls extending vertically from the bottom of the housing toward a housing opening. The test stand may include a cover, with which the housing opening can be closed. Materials for a seal between the cover and the housing or a coating of the cover can also be investigated with regard to their suitability in a battery by the test stand according to the invention. In the embodiment example with the cells arranged in a honeycomb pattern, the housing can have six side walls extending upward from a hexagonal housing base.

The housing can be made from metal. Other materials for the housing, for instance plastic or reinforced plastic, are conceivable.

Pressure limitation means can be provided to limit the pressure prevailing in the inner space of the housing. During thermal runaway or thermal propagation, very high pressures can occur in the inner space, which can be limited by a pressure relief valve, for example. Another and inexpensive version of pressure limitation means is a plug made of rock wool. Rock wool ensures continuous pressure limitation and good thermal insulation, so that not too much thermal energy is lost via the plug and a realistic simulation of the conditions in a real battery is possible. The presssure limitation means can be attached to the housing and/or the cover.

In the embodiment example with the cells arranged in the honeycomb pattern, a plate-shaped cell holder with several centering means, for example in the form of holes or round holes, can be provided in the housing by means of which the position of the initiation element and the position of the battery cells are determined. One cell is inserted into each hole, so that the cell holder specifies the honeycomb pattern. Preferably, the cell holder is located near the bottom of the housing or rests on it. The cell holder is preferably hexagonal in its basic shape and can be inserted into the housing with little play. The plate-shaped cell holder can be made of plastic and produced by a 3D printer.

A metal plate may be provided at an end of the battery cells preferably remote from the bottom of the housing. The metal plate in the housing of the test stand is intended to represent the wiring or interconnection of the battery cells in a battery (busbar). Like the wiring/interconnection of the battery cells, the metal plate exhibits high thermal conductivity. The metal plate may have means for holding or fixing the battery cells.

A further object of the invention, the provision of a method for testing a material which can be used in a battery, is solved with the combination of features according to claim 11.

The method of testing the material according to the invention provides for the use of the test stand described herein, wherein the at least one initiation cell is activated to start the thermal runaway, wherein the temperatures measured by the at least three temperature sensors during the thermal runaway are recorded, and wherein after the test run the state of the individual battery cells and the time course of the measured temperatures are evaluated.

The invention is explained in more detail with reference to the embodiments shown in the drawing.

It is shown in:
- Figure 1: schematically a test stand according to the invention;
- Figure 2: the view along line II - II in figure 1;
- Figure 3: an arrangement of battery cells and an initiation cell;
- Figure 4: an alternative arrangement of battery cells and initiation cells in two module carriers;
- Figure 5: a further example of an embodiment in longitudinal section;
- Figure 6: an arrangement of battery cells, initiation cell and temperature sensors;
- Figure 7: a housing base with holes for the temperature sensors; and
- Figure 8: another test stand not according to the invention with prismatic battery cells.

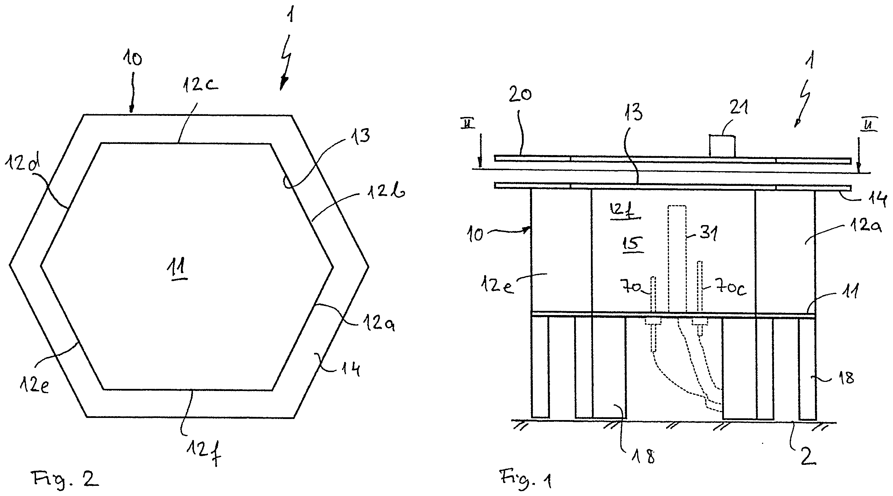

Figures 1 and 2 schematically show a test stand 1 with a metal housing 10 that has a hexagonal housing base 11. The basic shape of the hexagonal housing base 11 corresponds to an equilateral hexagon. The housing 10 has 6 side walls 12 (12a to 12e) which extend perpendicularly from the housing base 11 towards a housing opening 13. The housing opening 13 can be closed by a hexagonal cover 20. For fastening the cover 20, a housing flange 14 is provided on which the cover 20 rests flat when the housing opening 13 is closed. Not shown are fastening means, for example in the form of screws and nuts, by which the cover 20 and housing flange 14 can be firmly connected to each other. The cover 20 has a pressure relief valve 21 so that the pressure in an inner space 15 of the housing 10 is limited upwards. Additionally or alternatively, the pressure relief valve 21 can be attached to the housing base 11 or to one of the sidewalls 12.

In Figure 2, which represents the view along line II-II in Figure 1, the components that can be arranged in the inner space 15 of the housing 10 and are only indicated by dashed lines in Figure 1, are not shown.

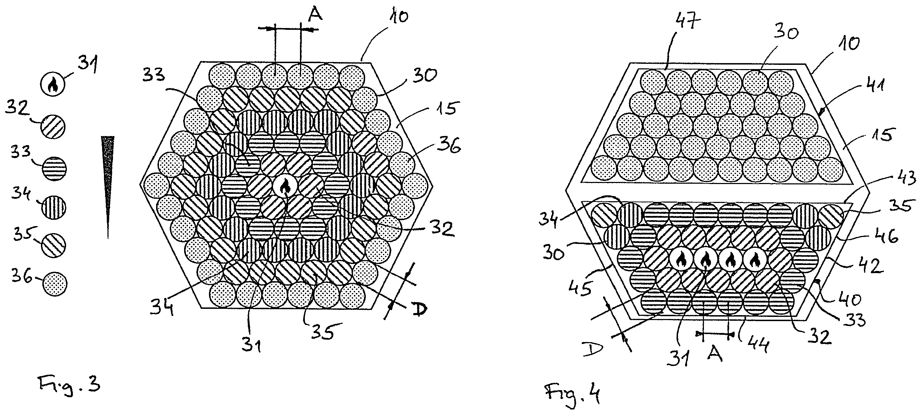

Figure 3 shows the housing 10 from above, whereby the housing flange 14 is not shown here. A number of cylindrical cells 30 are arranged in a honeycomb pattern in the housing 10. Each cell has the same diameter D.

A cylindrical initiation cell 31 is located in the center of the honeycomb pattern. 6 neighbouring cells in the form of first order battery cells 32 are arranged around the initiation cell 31, which lie on the corners of an equilateral hexagon and each have a distance A from the initiation cell 31 (in the honeycomb pattern, all cells 30 have the distance A from their neighbouring cells). In this embodiment example, the distance A corresponds to the diameter D of the cells 30. The distance A may also be greater than the diameter D, so that adjacent cells 30 are spaced apart and a gap is created between them. For example, the distance A can be 1,0 to 1,3 times the diameter D.

Around the six first order battery cells 32, twelve second order battery cells 33, which are also arranged in a hexagon, are connected in a radial direction to the outside. The second order battery cells 33 are followed by third order battery cells 34, fourth order battery cells 35 and fifth order battery cells 36.

Energy can be supplied to the initiation cell 31 so that this cell heats up. This is to simulate a thermal runaway of this cell. The increased temperature in the initiation cell 31 also leads to thermal runaway in the first order battery cells 32, so that a chain reaction takes place in the honeycomb pattern and the other battery cells are also affected by this thermal propagation. The scale in Figure 3, left side, shows that the lower order battery cells are more affected by thermal propagation than the higher order battery cells.

With the test stand 1 and the cells 30 arranged in a honeycomb pattern, the influence of a material filled in the gaps between the cells on the thermal propagation can be investigated, for example. If it is a material with very low thermal conductivity and high thermal (fire) resistance, a simulated thermal runaway of the centrally arranged cell 30 (see initiation cell 31) will not damage all cells 30 of the honeycomb pattern in the same way, but, for example, the first order battery cells 32 and the second order battery cells 33 will be completely affected and the higher order battery cells will only be partially or slightly affected.

Figure 4 shows a housing 10 in whose inner space 15 a first battery module 40 and a second battery module 41 are accommodated. The first battery module 40 comprises a first tray-shaped module carrier 42 with a trapezoidal carrier base. The carrier base has a longer base edge 43, a shorter base edge 44 and two legs 45, 46 connecting the two mutually parallel base edges 43, 44. In the module carrier 42 of the first battery module 40, four initiation cells 31 are arranged in a row adjacent to each other. Twelve first-order battery cells 32 surrounds these four initiation cells 31. Again, the cells 30 are arranged in a honeycomb pattern which allows the cells 30 to be equally spaced from directly adjacent cells. Second, third and fourth order battery cells 33, 34, 35 are also arranged in the module carrier 42.

A second module carrier 47 of the second battery module 41 is identical in construction to the first module carrier 42 of the first battery module 40. Only cells 30 are arranged in the module carrier 47 of the second battery module 41 which, after a simulated thermal runaway in the first battery module 40, have been practically unaffected by thermal propagation. With this test setup, the protective effect of battery modules can be checked in the test stand according to the invention.

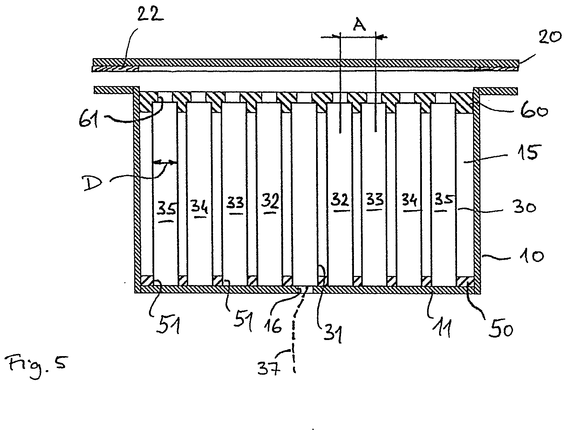

Figure 5 shows a longitudinal section of another embodiment in which the cells 30 are arranged in the inner space 15 of the housing 10, again in a honeycomb pattern with a central initiation cell 31. In addition to the central initiation cell 31, the honeycomb pattern comprises first order battery cells 32, second order battery cells 33, third order battery cells 34 and fourth order battery cells 35. A plate-shaped cell holder 50 rests on the housing base 11, in which a plurality of round openings 51 are provided. The openings 51 are arranged in a honeycomb pattern. The single battery cells 30 can be inserted into these openings 51 so that the plate-shaped cell holder 50 determines the position of the battery cells. The plate-shaped cell holder 50 can be made of plastic.

A metal plate 60 is provided at the end of each cell 30 remote from the base of the housing 11. The metal plate has a plurality of stepped apertures 61. The metal plate 60 is intended to simulate the wiring or metal interconnection of the individual cells 30 with each other. In the event of thermal propagation starting from a defective battery cell, a very large amount of heat can be transferred to the other cells 30, in particular via the thermally conductive metallic wiring. In the test stand according to the invention, this effect is simulated by the metal plate 60.

The cover 20 has a circumferential seal 22. This circumferential seal 32 can also be the subject of investigations to which extent the material of the circumferential seal 22 withstands the then prevailing conditions (temperature, pressure, fire resistance) during thermal propagation.

Figure 5 also shows that an opening 16 is provided in the housing base 11 through which a line 37 shown with a dashed line can activate or control the initiation cell 31.

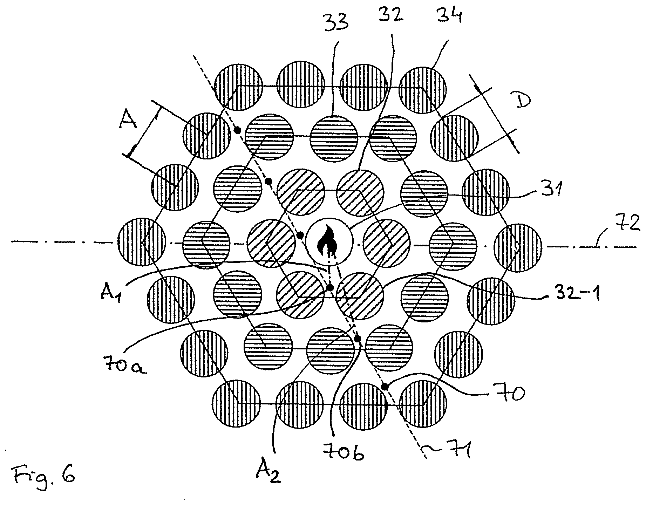

Figure 6 shows the cells 30 of Figure 5 in a honeycomb pattern from above. Here, too, it can be seen that the distance A between the longitudinal center axes of two adjacent cells 30 is greater than the diameter D. Each battery cell of the same order can be assigned an equilateral hexagon on which the battery cells are arranged either on the corners or the sides of the hexagon. The hexagon of the first order batteries 32 has a side length of A. The side length of the hexagon of the n-th order battery cells is n times A (n = 1, 2, 3, 4). It is noted that Figures 5 and 6 are not true-to-scale representations. For instance, the distance A can be in the range of 1,02 to 1,07 times D.

Temperature sensors 70 are arranged in the gaps between the individual battery cells 30, which are arranged here on a straight line 71 and are at different distances from the initiation cell 31. The temperature sensors 70, which preferably each record the temperature profile over time starting with the activation of the initiation cell 31, can be used to measure the thermal propagation as a function of time. A first temperature sensor 70a is arranged between the initiation cell 31 and a battery cell 32-1 of the first-order battery cells 32. A second temperature sensor 70b is arranged behind this battery cell 32-1. A distance A₁ is given between the initiation cell 31 and the first temperature sensor 70a. This distance A₁ is different from a distance A₂ between the initiation cell 31 and the second temperature sensor 70b. In the illustration of Figure 6, the distance A₂ is approximately twice as large as the distance A₁. Alternatively or additionally, the temperature sensors can also be arranged on other lines, for example on the dash-dotted line 72, which incidentally represents the line of intersection with the longitudinal section of Figure 5.

Figure 1 shows that the temperature sensors 70 can be arranged in such a way that they can measure the respective temperatures at different heights relative to the plane of the housing base 11. A third temperature sensor 70c is shown, which has another height than the other temperature sensors 70 (only one temperature sensor can be seen in Figure 1). This allows data to be acquired not only with respect to thermal propagation in the X-Y plane (plane parallel to the building floor 11), but also data for thermal propagation in the Z direction, i.e. perpendicular to the X-Y plane.

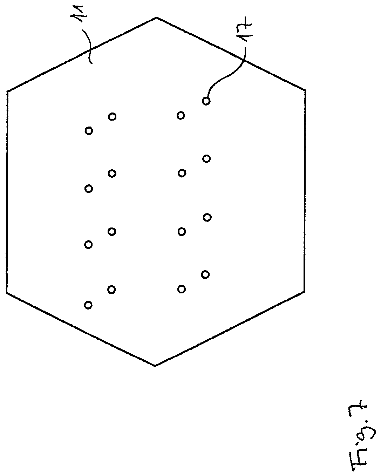

For positioning the temperature sensors 70, openings 17 (see Figure 7) can be provided in the housing base 11 through which the temperature sensors are inserted from below through the housing base 11 (see also Figure 1). The height of each temperature sensor 70 can be precisely adjusted by means of a screw connection, for example. The pattern of holes for temperature sensors shown in Figure 7 corresponds to a test setup according to Figure 4, in which the effectiveness of battery modules is investigated.

In order to leave a free space for the temperature sensors 70 between the base 11 of the housing and a ground 2 on which the test stand 1 stands, feet 18 are preferably provided at the corners of the hexagonal housing here (see Figure 1). Since high temperatures can develop in the housing 10 during a test, the feet 18 also ensure a necessary distance from the ground 2 so that it is not damaged by the heat development.

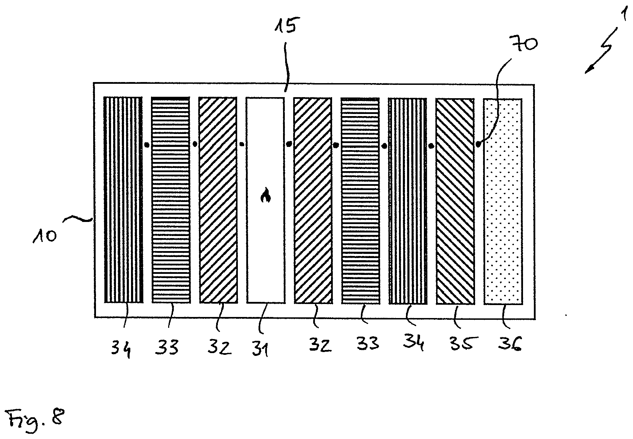

Figure 8 shows a further test stand 1 with a cuboid housing 10, in whose inner space 15 several prismatic or cuboid battery cells of different order 32, 33, 34, 35 and 36 are arranged. The test stand 1 is shown from above in the open state, i.e. without a cover. The initiation cell 31, which is also cuboidal, is located at a central position so that thermal propagation can take place in two directions (to the left and to the right in the figure 8 illustration). Not according to the invention, the temperature sensors 70 are each arranged on a straight line between two adjacent cells.

### List of reference signs

- 1: test stand
- 2: ground
- 10: housing
- 11: housing base
- 12: sidewall (12a to 12f)
- 13: housing opening
- 14: housing flange
- 15: inner space
- 16: opening
- 17: opening
- 18: foot
- 20: cover
- 21: pressure limitation means / pressure relief valve
- 22: seal
- 30: cell
- 31: initiation cell
- 32: first order battery cell
- 33: second order battery cell
- 34: third order battery cell
- 35: fourth order battery cell
- 36: fifth order battery cell
- 37: line
- 40: first battery module
- 41: second battery module
- 42: first module carrier
- 43: longer base edge
- 44: shorter base edge
- 45: leg
- 46: leg
- 47: second module carrier
- 50: cell holder
- 51: opening
- 60: metal plate
- 61: stepped opening
- 70: temperature sensor (70a, 70b, 70c)
- 71: straight line
- 72: straight line

## Claims

1. A test stand (1) for evaluating a material to be used in a battery under conditions that may occur during a thermal runaway, the test stand (1) comprising a housing (10), wherein in an inner space (15) of the housing (10) at least one activatable initiation cell (31), a plurality of cylindrical battery cells (32, 33, 34, 35, 36) and the material to be evaluated being arranged in the interior space (15) or on the housing (10), a first temperature sensor (70a) and at least one second temperature sensor (70b) being arranged in the inner space (15), a distance A₁ between the initiation cell (31) and the first temperature sensor (70a) and a distance A₂ between the initiation cell (31) and the second temperature sensor (70b) being different from one another, **characterized in that** the housing has a housing base (11) which lies in an X-Y plane and from which also the initiation cell and the battery cells extend perpendicularly in a Z-direction, wherein a third temperature sensor (70c) is provided which measures the temperature at a height in the Z-direction which is different from the height at which the temperature is measured by the first temperature sensor and/or the temperature is measured by the second temperature sensor, wherein at least one of the temperature sensors (70) projects vertically upwards from below through an opening (17) in the housing base (11), the housing (10) is supported on a plurality of feet (18) so that a free space remains between the housing base (11) and a ground (2) on which the test stand (1) stands with the feet (18), the free space being used for the mounting and arrangement of the temperature sensors.

2. A test stand (1) according to claim 1, **characterized in that** an n-th order battery cell is arranged between the initiating cell (31) and an (n+1)-th order battery cell, and wherein, as viewed from the initiating cell (31), the first temperature sensor (70a) is provided in front of the n-th order battery cell and the second temperature sensor (70b) is provided behind the n-th order battery cell.

3. A test stand (1) according to claim 1 or 2, **characterized in that** the initiating cell (32) and the battery cells (32, 33, 34, 35, 36) are arranged in a honeycomb pattern in which a cell not located at the border of the honeycomb pattern has six neighboring cells each located on the corners of an equilateral hexagon having a side length corresponding to a distance between the cell and the neighboring cell.

4. Test stand (1) according to claim 1 or 2, **characterized in that** the initiation cell (31) and the battery cells (32, 33, 34, 35, 36) are arranged side by side in a row.

5. Test stand (1) according to any one of the claims 1 to 4, **characterized in that** the height of the at least one of the temperature sensors (70) is fixable in the inner space (15) by a screw connection.

6. Test stand (1) according to any one of claims 1 to 5, **characterized in that** the temperature sensors (70) are arranged on a straight line (71).

7. Test stand (1) according to one of claims 1 to 6, **characterized in that** the housing (10) has side walls (12) which extend from the housing base (11) perpendicularly in the direction of a housing opening (13), a cover (20) being provided with which the housing opening (13) can be closed.

8. Test stand (1) according to one of claims 1 to 7, **characterized in that** a metal plate (60) provided with openings (61) is provided at an end of the cells (30) facing away from the housing base (11).

9. Method for testing a battery component with a test stand (1) according to any one of claims 1 to 8, wherein the at least one initiation cell (31) is activated to start the thermal runaway, wherein the temperatures measured by the at least three temperature sensors (70) during the thermal runaway are recorded, and wherein after the thermal runaway the state of the individual battery cells (32, 33, 34, 35, 36) and the time curves of the measured temperatures are evaluated.

## Patentansprüche

1. Prüfstand (1) zur Bewertung eines in einer Batterie zu verwendenden Materials unter Bedingungen, die bei einem thermischen Durchgehen auftreten können, wobei der Prüfstand (1) ein Gehäuse (10) umfasst, wobei in einem Innenraum (15) des Gehäuses (10) mindestens eine aktivierbare Zündzelle (31) angeordnet ist, wobei mehrere zylindrische Batteriezellen (32, 33, 34, 35, 36) und das zu bewertende Material im Innenraum (15) oder am Gehäuse (10) angeordnet sind, wobei ein erster Temperatursensor (70a) und mindestens ein zweiter Temperatursensor (70b) im Innenraum (15) angeordnet sind, wobei ein Abstand Ai zwischen der Zündzelle (31) und dem ersten Temperatursensor (70a) und ein Abstand A₂, wobei die Zündzelle (31) und der zweite Temperatursensor (70b) voneinander verschieden sind, **dadurch gekennzeichnet, dass** das Gehäuse einen Gehäuseboden (11) aufweist, der in einer X-Y-Ebene liegt und von dem aus sich auch die Zündzelle und die Batteriezellen senkrecht in eine Z-Richtung erstrecken, wobei ein dritter Temperatursensor (70c) bereitgestellt ist, der die Temperatur in einer Höhe in Z-Richtung misst, die verschieden ist von der Höhe, in der die Temperatur durch den ersten Temperatursensor gemessen wird und/oder die Temperatur durch den zweiten Temperatursensor gemessen wird, wobei mindestens einer der Temperatursensoren (70) senkrecht von unten nach oben durch eine Öffnung (17) im Gehäuseboden (11) ragt, das Gehäuse (10) auf mehreren Füßen (18) ruht, so dass zwischen dem Gehäuseboden (11) und einem Untergrund (2), auf dem der Prüfstand (1) mit den Füßen (18) steht, ein Freiraum verbleibt, der zur Montage und Anordnung der Temperatursensoren genutzt wird.

2. Prüfstand (1) nach Anspruch 1, **dadurch gekennzeichnet, dass** eine Batteriezelle n-ter Ordnung zwischen der Zündzelle (31) und einer Batteriezelle (n+1)-ter Ordnung angeordnet ist, und wobei, von der Zündzelle (31) aus gesehen, der erste Temperatursensor (70a) vor der Batteriezelle n-ter Ordnung und der zweite Temperatursensor (70b) hinter der Batteriezelle n-ter Ordnung bereitgestellt ist.

3. Prüfstand (1) nach Anspruch 1 oder 2, **dadurch gekennzeichnet, dass** die Zündzelle (32) und die Batteriezellen (32, 33, 34, 35, 36) in einem Wabenmuster angeordnet sind, wobei eine Zelle, die sich nicht am Rand des Wabenmusters befindet, sechs Nachbarzellen hat, die sich jeweils an den Ecken eines gleichseitigen Sechsecks befinden, dessen Seitenlänge einem Abstand zwischen der Zelle und der Nachbarzelle entspricht.

4. Prüfstand (1) nach Anspruch 1 oder 2, **dadurch gekennzeichnet, dass** die Zündzelle (31) und die Batteriezellen (32, 33, 34, 35, 36) in einer Reihe nebeneinander angeordnet sind.

5. Prüfstand (1) nach einem der Ansprüche 1 bis 4,
**dadurch gekennzeichnet, dass** die Höhe des mindestens einen Temperatursensors (70) im Innenraum (15) durch eine Schraubverbindung fixierbar ist.

6. Prüfstand (1) nach einem der Ansprüche 1 bis 5,
**dadurch gekennzeichnet, dass** die Temperatursensoren (70) auf einer Geraden (71) angeordnet sind.

7. Prüfstand (1) nach einem der Ansprüche 1 bis 6,
**dadurch gekennzeichnet, dass** das Gehäuse (10) Seitenwände (12) aufweist, die sich vom Gehäuseboden (11) senkrecht in Richtung einer Gehäuseöffnung (13) erstrecken, wobei ein Deckel (20) bereitgestellt ist, mit dem die Gehäuseöffnung (13) verschließbar ist.

8. Prüfstand (1) nach einem der Ansprüche 1 bis 7,
**dadurch gekennzeichnet, dass** an einem dem Gehäuseboden (11) abgewandten Ende der Zellen (30) eine mit Öffnungen (61) bereitgestellte Metallplatte (60) bereitgestellt ist.

9. Verfahren zum Testen einer Batteriekomponente mit einem Prüfstand (1) nach einem der Ansprüche 1 bis 8, wobei zum Auslösen des thermischen Durchgehens die mindestens eine Zündzelle (31) aktiviert wird, wobei die während des thermischen Durchgehens von den mindestens drei Temperatursensoren (70) gemessenen Temperaturen aufgezeichnet werden, und wobei nach dem thermischen Durchgehen der Zustand der einzelnen Batteriezellen (32, 33, 34, 35, 36) und die zeitlichen Verläufe der gemessenen Temperaturen ausgewertet werden.

## Revendications

1. Banc d'essai (1) permettant d'évaluer un matériau à utiliser dans une batterie dans des conditions pouvant survenir lors d'un emballement thermique, le banc d'essai (1) comprenant un boîtier (10), dans lequel, dans un espace intérieur (15) du boîtier (10), au moins un élément d'initiation activable (31), une pluralité d'éléments de batterie cylindriques (32, 33, 34, 35, 36) et le matériau à évaluer sont disposés dans l'espace intérieur (15) ou sur le boîtier (10), un premier capteur de température (70a) et au moins un deuxième capteur de température (70b) sont disposés dans l'espace intérieur (15), une distance A₁ entre l'élément d'initiation (31) et le premier capteur de température (70a) et une distance A₂ entre l'élément d'initiation (31) et le deuxième capteur de température (70b) sont différentes l'une de l'autre, **caractérisé en ce que** le boîtier a une base de boîtier (11) qui se trouve dans un plan X-Y et à partir de laquelle l'élément d'initiation et les éléments de la batterie s'étendent également perpendiculairement dans une direction Z, dans lequel un troisième capteur de température (70c) est placé, lequel mesure la température à une hauteur dans la direction Z qui est différente de la hauteur à laquelle la température est mesurée par le premier capteur de température et/ou la température est mesurée par le deuxième capteur de température, dans lequel au moins un des capteurs de température (70) fait saillie verticalement vers le haut depuis le dessous à travers une ouverture (17) dans la base de boîtier (11), le boîtier (10) repose sur une pluralité de pieds (18) de sorte qu'il reste un espace libre entre la base de boîtier (11) et un sol (2) sur lequel le banc d'essai (1) repose avec les pieds (18), l'espace libre étant utilisé pour le montage et l'agencement des capteurs de température.

2. Banc d'essai (1) selon la revendication 1, **caractérisé en ce qu'**un élément de batterie d'ordre n est disposé entre l'élément d'initiation (31) et un élément de batterie d'ordre (n+1), et dans lequel, tel que vu depuis l'élément d'initiation (31), le premier capteur de température (70a) est placé devant l'élément de batterie d'ordre n et le deuxième capteur de température (70b) est placé derrière l'élément de batterie de d'ordre n.

3. Banc d'essai (1) selon la revendication 1 ou 2, **caractérisé en ce que** l'élément d'initiation (32) et les éléments de batterie (32, 33, 34, 35, 36) sont disposés selon un motif en nid d'abeille dans lequel un élément non situé à la limite du motif en nid d'abeille a six éléments voisins situés chacun sur les coins d'un hexagone équilatéral ayant une longueur de côté correspondant à une distance entre l'élément et l'élément voisin.

4. Banc d'essai (1) selon la revendication 1 ou 2, **caractérisé en ce que** l'élément d'initiation (31) et les éléments de batterie (32, 33, 34, 35, 36) sont disposés côte à côte dans une rangée.

5. Banc d'essai (1) selon l'une quelconque des revendications 1 à 4,
**caractérisé en ce que** la hauteur de l'au moins un des capteurs de température (70) peut être fixée dans l'espace intérieur (15) par une liaison à vis.

6. Banc d'essai (1) selon l'une quelconque des revendications 1 à 5,
**caractérisé en ce que** les capteurs de température (70) sont disposés sur une ligne droite (71).

7. Banc d'essai (1) selon l'une quelconque des revendications 1 à 6,
**caractérisé en ce que** le boîtier (10) a des parois latérales (12) qui s'étendent à partir de la base de boîtier (11) perpendiculairement dans la direction d'une ouverture de boîtier (13), un couvercle (20) étant placé, avec lequel l'ouverture de boîtier (13) peut être fermée.

8. Banc d'essai (1) selon l'une quelconque des revendications 1 à 7,
**caractérisé en ce qu'**une plaque métallique (60) pourvue d'ouvertures (61) est placée à une extrémité des éléments (30) tournée vers l'extérieur de la base de boîtier (11).

9. Procédé d'essai d'un composant de batterie avec un banc d'essai (1) selon l'une quelconque des revendications 1 à 8, dans lequel l'au moins un élément d'initiation (31) est activé pour démarrer l'emballement thermique, dans lequel les températures mesurées par les au moins trois capteurs de température (70) pendant l'emballement thermique sont enregistrées, et dans lequel, après l'emballement thermique, l'état des éléments de batterie individuels (32, 33, 34, 35, 36) et les courbes temporelles des températures mesurées sont évalués.
